# EUROPEAN PATENT SPECIFICATION

(11) **EP 2 730 992 B1**
(45) Date of publication and mention of the grant of the patent: **06.05.2020**
(21) Application number: 13191318.8
(22) Date of filing: 02.11.2013
(51) Int. Cl.: B29C 63/00, G06F 1/16, H04B 1/3888, B29C 63/02, B29L 31/34, H04M 1/02, H04M 1/18

(54) **Device and method for installing a screen protector**
Vorrichtung und Verfahren zur Einrichtung eines Bildschirmschutzes
Dispositif et procédé permettant d'installer un écran protecteur

(30) Priority: 13.11.2012 TW 101221927
(43) Date of publication of application: 14.05.2014
(73) Proprietor: Hsu, Chan Jung, 100 Taipei City (TW)
(72) Inventor: Hsu, Chan Jung, Taipei City 100 (TW); Wu, Ching Shan, Taipei City 114 (TW)
(74) Representative: Lang, Christian

(56) References cited:
- KR-U- 20110 008 023
- US-A1- 2012 110 868
- ISTT CO.; icapslae: "How to install Built-in Screen protector with smart applicator for iPhone 5.", YouTube , 18 September 2012 (2012-09-18), XP054975835, Retrieved from the Internet: URL:https://www.youtube.com/watch?v=hCZKkG oTsOo [retrieved on 2015-04-24] -& ISTT Co.; Icapslae: "How to install Built-in Screen protector with smart applicator for iPhone 5.", YouTube , 18 September 2012 (2012-09-18), XP055188453, Retrieved from the Internet: URL:https://www.youtube.com/watch?v=hCZKkG oTsOo [retrieved on 2015-05-11]
- Perfect Fit: "iPhone 5 Screen Shield Screen Protector with Perfect Fit Applicator | Perfect Fit Tech Screen Shield Screen Protector with the Perfect Fit Applicator", , 26 September 2012 (2012-09-26), XP055184448, News blog of Perfect Fit Technologies Retrieved from the Internet: URL:http://web.archive.org/web/20120930001 426/http://www.perfectfittech.com/blogs/ne ws/6633742-iphone-5-screen-shield-screen-p rotector-with-perfect-fit-applicator [retrieved on 2015-04-20]

## Description

### FIELD OF THE INVENTION

• Embodiments of the present invention relate to device and method for installing a screen protector, especially toward a frame-like device integrated with a screen protector that makes install with ease and precision.

### BACKGROUND

• It is now common practice to apply a protective plastic film to the display screen of a newly bought mobile phone, laptop computer, tablet computer, or the like. This kind of films, generally known as screen protectors, are transparent thin plastic films capable of protecting screens from damage by an external object without interfering with the display of contents on the screens.

• While the advantages of screen protectors are well known, the operation of applying such films can be a nightmare to many. This is simply because one who has little experience in film application must find it difficult to apply a thin film to the intended position on a screen, not to mention leaving no air bubbles in between the film and the screen after the application.

• To enable an amateur to achieve professional film application results, a number of auxiliary tools were developed for the application of screen protectors, some examples of which tools are briefly described below.

• US8369072 discloses a screen protector applicator including a cradle and a screen protector placed on the bottom surface of the cradle. Both the cradle and the screen protector are dimensioned and configured to conform to the portable electronic device to which the screen protector is to be applied. By placing the portable electronic device into the cradle, the screen protector is applied to the intended application surface of the portable electronic device. According to the design of US8369072, the screen protector is adhesively attached to the bottom surface of the cradle via a double-sided adhesive tape, and because of that, the following two scenarios may take place during the application process. In the first scenario, the screen protector, even though applied to the application surface of the electronic device with success, is peeled off, or displaced with respect to, the application surface when the electronic device is removed from the cradle. This tends to happen if the double-sided adhesive tape is too tacky, given the fact that the separation between the screen protector and the cradle is a separation between two surfaces. Should the screen protector be displaced, air bubbles may be formed as a result. In the second scenario, the screen protector is separated from the cradle prematurely by a downward pulling force applied to peel off the release film of the screen protector from below, and the second scenario tends to happen if the double-sided adhesive tape is not tacky enough. Therefore, the release film in US8369072 must be carefully peeled off upward to prevent the release film from separation from the cradle, but peeling off the release film upward will expose the screen protector to dust or other sources of contamination.

• US20130020020 A1 also discloses a tool for screen protector application and includes a jig composed of a top-layer element, a middle-layer element, and a bottom-layer element which can be separated from one another. An inner portion of the middle-layer element is cut away from the middle-layer element according to the shape of the panel cell phone to which the screen protector is to be applied. Thus, a receiving space is formed in the middle-layer element, and the inner portion cut away from the middle-layer element functions as the bottom-layer element. Moreover, an inner portion of the top-layer element is cut away from the top-layer element according to the shape of the screen protector, thereby forming a space in the top-layer element. To apply the screen protector with the jig, the following steps are performed: removing the bottom-layer element from the jig; inserting the predetermined application surface of the panel cell phone into the receiving space of the middle-layer element from below; inserting an adhesive side of the screen protector into the space of the top-layer element; attaching the adhesive side of the screen protector to the predetermined application surface of the panel cell phone; and removing the panel cell phone from the receiving space of the middle-layer element from below. US20130020020 is flawed in that the thin screen protector is subject to misalignment when being inserted into the receiving space of the top-layer element, and such misalignment will prevent the screen protector from being precisely placed at the intended position on the panel cell phone. Another shortcoming of US20130020020 is that the periphery of the screen protector may inadvertently adhere to the sidewall of the space in the top-layer element, causing air bubbles between the screen protector and the intended application surface of the panel cell phone.

• The utility model KR 2011 0008023 U further discloses a device for installing a screen protector comprising a screen protector with a protective layer, an adhesive film layer and a release layer bonded together and a mold-like application apparatus comprising an internal hollow region for containing the targeted electronic device. The installation includes the steps of inserting an electronic device into the internal hollow region of the application apparatus, removing the release layer and then attaching the adhesive film layer to the surface of the mobile device. Finally, the device with the screen protector can be taken out of the internal hollow region of the application apparatus and the protective layer can be removed from the surface of the adhesive film layer.

### SOME EXEMPLARY EMBODIMENTS

• These and other needs are addressed by the invention, wherein an approach is provided for devices and methods for installing a screen protector which allow the screen protector to be conveniently, precisely, and successfully attached to a screen surface of an electronic device.

• According to an embodiment of the present invention, a device for installing a screen protector according to claim 1 is provided.

• According to another embodiment of the present invention, a method for installing a screen protector according to claim 13 is provided.

### BRIEF DESCRIPTION OF THE DRAWINGS

• The invention is illustrated by way of example, and not by way of limitation, in the figures of the accompanying drawings in which like reference numerals refer to similar elements and in which:
• FIG. 1 is an exploded perspective view of the screen protector application device according to the first preferred embodiment of the present invention;
• FIG. 2 is an assembled top view of the screen protector application device according to the first preferred embodiment of the present invention;
• FIG. 3 is a front sectional view of the screen protector application device according to the first preferred embodiment of the present invention;
• FIGs. 4A to 4D schematically show how a screen protector is applied to a surface of an electronic device by means of the screen protector application device according to the first preferred embodiment of the present invention;
• FIG. 5 is an assembled top view of the screen protector application device according to the second preferred embodiment of the present invention;
• FIG. 6 is a partial front sectional view of the screen protector application device according to the second preferred embodiment of the present invention;
• FIG. 7 is a partial front sectional view of the screen protector application device according to the third preferred embodiment of the present invention, showing in particular a tongue externally affixed to the upper surface of an extension portion on a longitudinal side of a release layer;
• FIG. 8 is an exemplary view of other embodiment in accordance with the present invention.

### DESCRIPTION OF THE PREFERRED EMBODIMENT

• Embodiments of the devices and/or methods are disclosed. In the following description, for purposes of explanation, numerous specific details are set forth in order to provide a thorough understanding of the embodiment of the disclosure. It is apparent, however, to one skilled in the art that the present disclosure may be practiced without these specific details or with an equivalent arrangement.

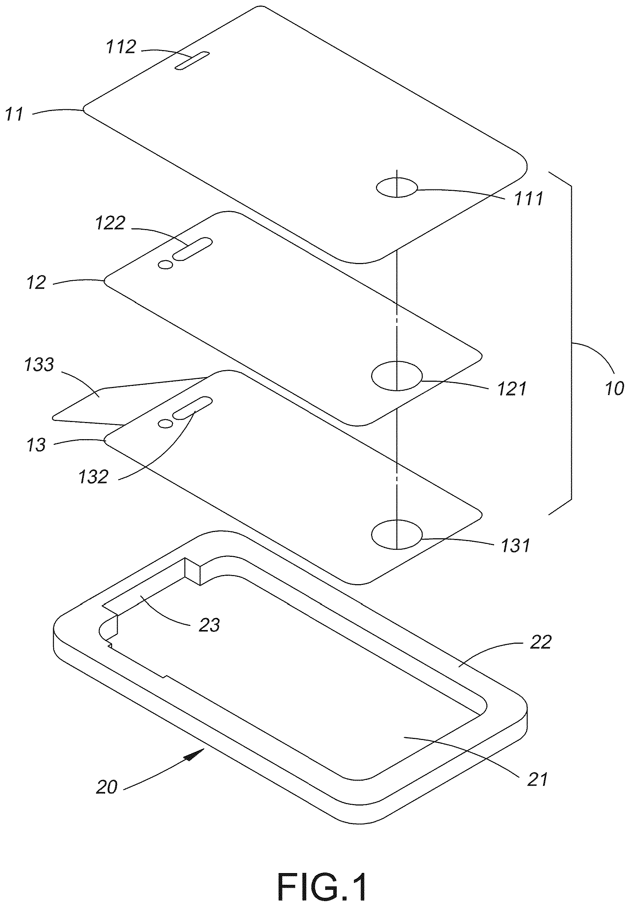

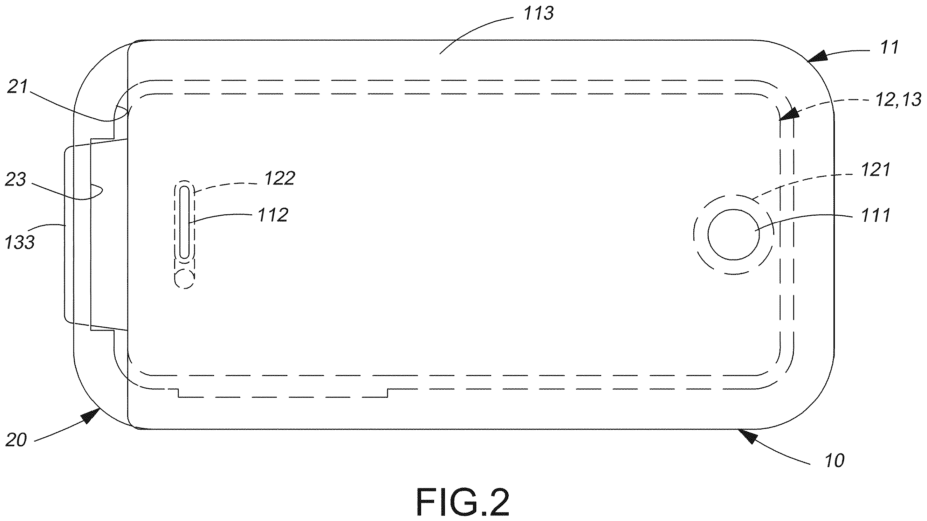

• With reference to FIGs. 1 and 2, an device in accordance with an embodiment of the present invention, comprises a screen protector 10 and an application apparatus 20. The screen protector 10 sequentially includes, from top to bottom, a protective layer 11, an adhesive film layer 12 and a release layer 13 bonded together. The surface to the protector layer 11 is greater than the adhesive film layer 12 and the release layer 13, and the surface of the adhesive film layer 12 is no larger (equally or smaller) than the release layer 13. Accordingly, the protective layer 11 and the release 13 are able to fully cover on two side of the adhesive film layer 12, and protect the adhesive film layer 12 from dusts or other sources of contamination before use. The openings 111, 121, 131 and the grooves 112, 122, 132 in the protective layer 11, the adhesive film layer 12, and the release layer 13 correspond respectively to apertures reserved for the functional structures (e.g., loudspeakers and buttons) of the electronic device (not shown) to which the screen protector 10 is to be applied. That is to say, the positions and shapes of the openings 111, 121, 131 and of the grooves 112, 122, 132 may vary with such functional structures.

• The application apparatus 20 is a frame-like structure being configured for placing the screen protector and having a certain thickness that can be easily held by hand for installing the screen protector. As shown in Fig. 1, the application apparatus 20 comprises an internal hollow region 21, a frame-shaped top surface 22 and a notch 23.

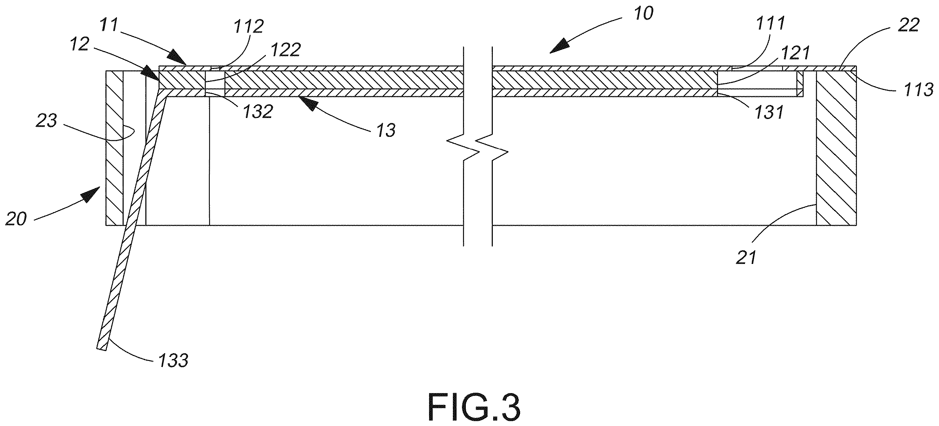

• In an embodiment, as shown in FIGs. 1, 2 and 3, the protective layer 11 has a peripheral portion 113 extended outwardly beyond edges of the adhesive film layer 12 or the release layer 13. The peripheral portion 113 is configured for attaching to the top surface 22 of the application apparatus 20 that makes the adhesive film layer 12 and the release layer 13 placed inside the internal hollow region 21 where are surround by the top of the internal hollow region 21. The release layer 13 further comprises a tongue 133 formed on a longitudinal side of the release layer 13 corresponded to the notch 23 of the application apparatus 20. As the screen protector 10 is held by the application apparatus 20, the tongue 133 extends through the notch 23. In this manner, the release layer 13 can be easily peeled off from the adhesive film layer 12 by pulling the tongue 133

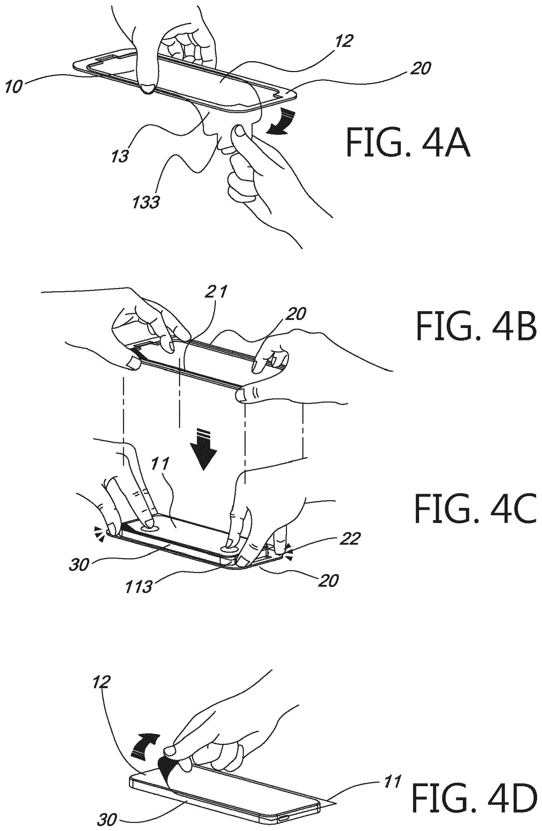

• In order to a better understanding, Figs. 4A to 4D illustrating respective operating steps for installing the screen protector in accordance with the embodiment of the present invention. However, before operation, it is advisable to remove any existing screen protector and clean the to-be-protected surface of the targeted electronic device.

• In actual operation, the release layer 13 is firstly peeled off from the adhesive film layer 12 which by puling the tongue 133 downwardly and outwardly under the application apparatus 20 (Fig. 4A). Next, mounting the application apparatus 20 toward the outer frame of the targeted electronic device 30 to which the screen protector 10 is to be applied. The bottom surface of the application apparatus 20 is preferably held parallel to the to-be-protected surface of the targeted electronic device 30. Once the adhesive film layer 12 of the screen protector 10 touches the surface of the targeted electronic device 30 as the application apparatus 20 continually move downwardly. The adhesive film layer 20 will rapidly and compliantly attach to and thus cover the surface of the targeted electronic device 30 (Fig. 4B). By applying a slight force to the application device 20 and moving it further downward, the peripheral portion 113 of the protective layer 11 is forced to detach from the frame-shaped top surface 22 of the application apparatus 20. It makes the screen protector 10 separated from the application apparatus 20 completely (Fig. 4C). Finally, removing the application apparatus 20 from the targeted electronic device 30 after peeling the protective layer 11 off that is advised starting from a corner of the screen protector 10 (Fig. 4D). Accordingly, the adhesive film layer 12 is adhesively and precisely attached to the intended position on the surface of the targeted electronic device, and thus the installation is complete.

• It is noted that the internal hollow region 21 of the application apparatus may vary in shape and size due to the difference of the targeted electronic device. Also, the gap between the internal hollow region 21 and the contour of the electronic device can be adjusted according to the desired degree of fit.

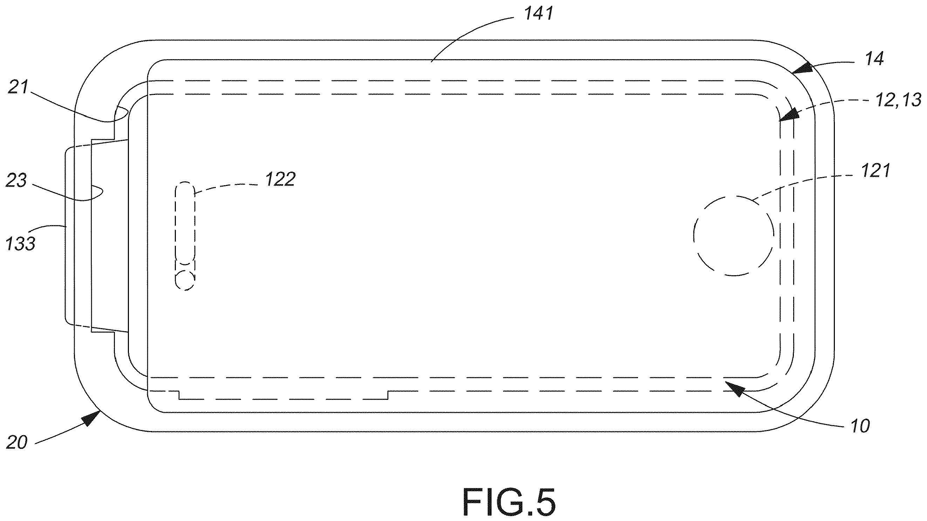

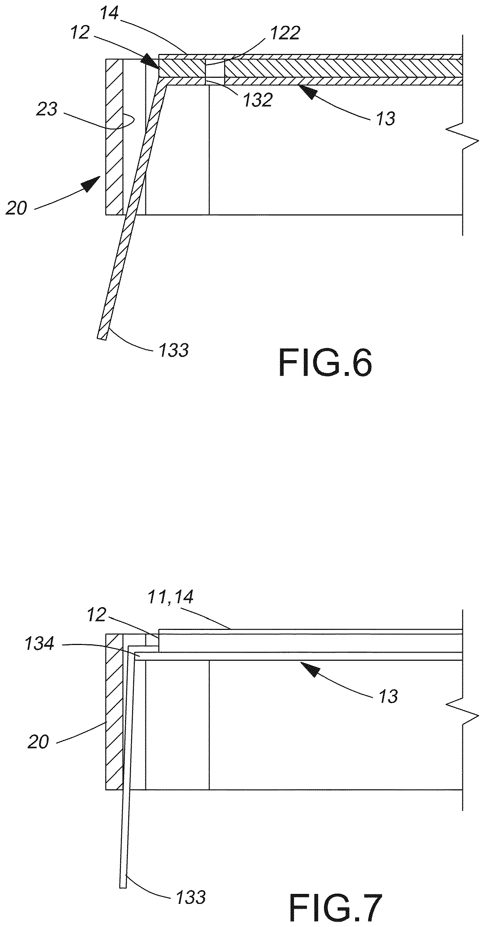

• With reference to Figs. 5 and 6 illustrating another embodiment of the present invention which the protective layer 11 is replaced by a connecting layer or an protective layer 14 that the screen protector 10 may bonded together with the adhesive film layer 12 and the underlying release layer 13. In this embodiment, the connecting layer or the protective layer 14 is configured for attaching the screen protector 10 to the frame-shaped top surface of the application apparatus 20, and serves to enable placement of the screen protector at an appropriate position inside the internal hollow region 21 of the application apparatus 20. In this manner, the screen protector 10 can subsequently adhere to the surface of a targeted electronic device with precision.

• As shown in Fig. 5, in this embodiment, the area of the protective layer 14 is greater than the adhesive film layer 12 or the release layer 13, is smaller than the area enclosed by the outer contour of the application apparatus 20, and comprises a peripheral portion 141. The peripheral portion 141 is extended outwardly to the frame-shaped top surface of the application apparatus 20, and is spaced from the outer contour of the application apparatus 20.

• In addition, the bottom surface of the protective layer 14 may has a low-tack adhesive layer (not shown) to enable adhesive attachment, and is located between a region of the peripheral portion 141 and the frame-shaped top surface of the application apparatus 20.

• As shown in Fig. 6, it is noted that the protective layer 14 need not be provided with the opening 111 and the groove 112 as protective layer 11 shown in Fig. 1, the function of the protective layer 14 is to affix the adhesive film layer 12 and the release layer 13 to the application apparatus 20, and is therefore different from the protective layer 11.

• With reference to Fig. 7 illustrating yet another embodiment, as mentioned above, the release layer 13 has a longitudinal side integrally formed with the tongue 133 to facilitate the peeling of the release layer 13 off the adhesive film layer 12. In this embodiment, as shown in Fig. 7, the tongue 133 is externally affixed to an upper surface of an extension portion 134 on a longitudinal side of the release layer 13.

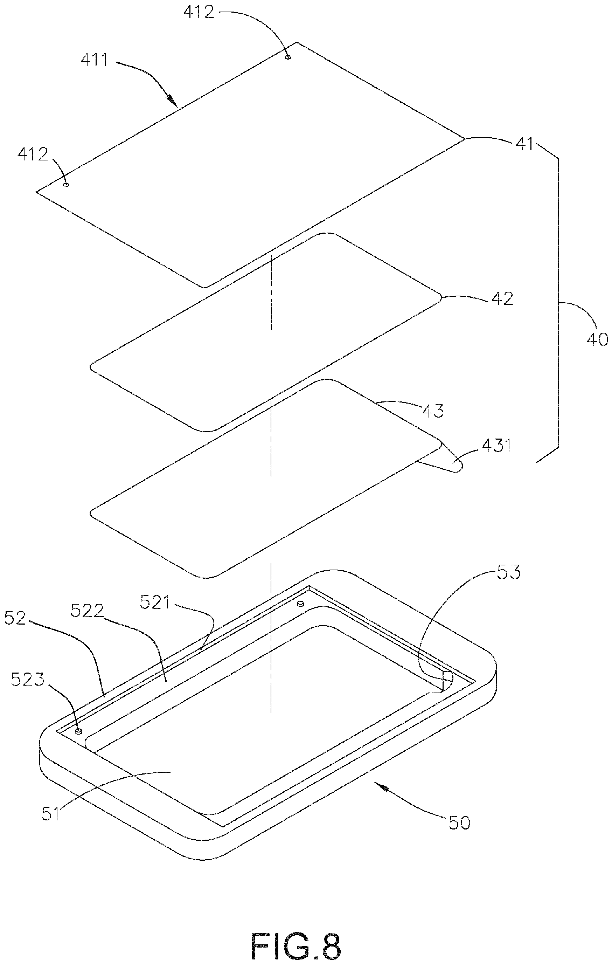

• With reference to Fig. 8 illustrating other embodiment of the device in accordance with the present invention. In this embodiment, the application apparatus 50 has a sharp edge 521 downwardly from the frame-shaped top surface to form a padding portion 522, and comprises at least two protrusions 523 mounted on at least one latitudinal side of the padding portion 522 of the application apparatus 50. In this embodiment, as shown in Fig. 8, the sharp edge 521 are integrally formed by a border 52 on the contour of the application apparatus 50. However, a person skilled in art may realize that the sharp edge 521 is not limited to be formed by the border 52.

• As shown in Fig. 8, the two spaced protrusions 523 are aligned along the latitudinal side of the padding portion 522 of the application apparatus 50. However, a person skilled in the art may realize that the protrusions 523 may also mounted respectively on each latitudinal side of the padding portion 522 of the application apparatus 50, and the positions of the protrusions 523 may be opposite to each other at the middle or corners of the padding portion 522 of the application apparatus 50.

• The screen protector 40 sequentially includes, from top to bottom, a protective layer 41, an adhesive film layer 42 and a release layer 43 bonded together. The surface to the protector layer 41 is greater than the adhesive film layer 42 and the release layer 43, and the surface of the adhesive film layer 42 is no larger (equally or smaller) than the release layer 13. The protective layer 41 further comprises at least two openings 412 on at least one latitudinal side of the peripheral portion 411 corresponded to the protrusions 523. The openings 412 of the protective layer 41 are configured for coupling the screen protector 40 to the application apparatus 50 by clipping into the protrusions 523. Since the protective layer 41 is larger than the adhesive film layer 42 and the release layer, the exceed area of the protective layer 41 may further comprises a low-tack adhesive tape (not shown) on the same side of the adhesive film layer 42. The width of the adhesive tape is corresponding to the width of the padding portion 522.

• Accordingly, in this embodiment, a person may stick the adhesive side of protective layer 41 on the padding portion 522 by positioning the openings 412 toward the protrusions 523. When the protective layer 41 placed intact on the padding portion 522, which means the screen protector is perfect aligned. However, it is not necessary to have the padding portion 522 as the openings 412 and protrusions 523 being engaged intact to each other.

• When the protective layer 41 is attached to the padding portion 522, the person can then peel the release layer 43 underneath the application apparatus 50 and install the adhesive film layer 42 on the surface of a targeted electronic device with precision. Finally, removing the protective layer 41 from the adhesive film 42 and the padding portion 522 by moving the application apparatus 50 downwardly and peeling off the protective layer 41. The installation of a screen protector 40 is completed.

• Further, as shown in Fig. 8, in this embodiment, the notch 53 originally formed at a longitudinal side (the edge) of the application apparatus 50 can be formed at the corner of the application apparatus 50. The position of the tongue 431 of the release layer 43 is corresponding to the notch 53. The benefit of this embodiment shown in Fig. 8 is to allow a person reuse this application apparatus 50 by replace a new screen protector 40, and install the new screen protector 40 with same procedure as above mentioned.

• While the invention has been described in connection with a number of embodiments and implementations, the invention is not so limited but covers various obvious modifications and equivalent arrangements, which fall within the purview of the appended claims. Although features of the invention are expressed in certain combinations among the claims, it is contemplated that these features can be arranged in any combination and order.

## Claims

1. A device for installing a screen protector, comprising:
a screen protector (10), sequentially including, from top to bottom, a protective layer (11), an adhesive film layer (12) and a release layer (13) bonded together, wherein the surface of the protector layer (11) is greater than the adhesive film layer (12) and the release layer (13), and the surface of the adhesive film layer (12) is no larger than the release layer (13), so that the protective layer (11) and the release layer (13) fully cover the two sides of the adhesive film layer (12) to protect the adhesive film layer (12) from dusts or other sources of contamination before use, wherein the protective layer (11), the adhesive film layer (12), and the release layer (13) have openings (111, 121, 131) and grooves (112, 122, 132) corresponding respectively to apertures reserved for the functional structures of a targeted electronic device (30) to which the screen protector (10) is to be applied, an application apparatus (20) being a frame-like structure comprising an internal hollow region (21) formed as through-hole for containing the screen protector (10) and a frame-shaped top surface (22) and being configured for attaching the adhesive film layer (12) of the screen protector (10) onto a surface of the targeted electronic device (30), and having a certain thickness that can be easily held by hand for installing the screen protector (21),
wherein the protective layer (11) comprises a peripheral portion (113) extended outwardly beyond the adhesive film layer (12) or the release layer (13) **characterised in that**
the peripheral portion (113) attaches to the frame-shaped top surface (22), and the application apparatus (20) having a certain thickness smaller than the thickness of the targeted electronic device (30), so that the application apparatus (20) is movable downward vertically along an outer contour of the targeted electronic device (30) after removing a release layer (13) bonded under the adhesive film layer (12).

2. The device as claimed in claim 1, wherein the release layer (13) further comprises a tongue (133) formed at a longitudinal side of the release layer (13).

3. The device as claimed in claim 2, wherein the tongue (133) is integrally formed with the release layer (13).

4. The device as claimed in claim 2, wherein the tongue (133) is externally affixed to the release layer (13), and is selectively affixed to an extension portion (134) of the release layer (13).

5. The device as claimed in claim 2, wherein the internal hollow region (21) of the application apparatus (20) has a side formed with a notch (23) corresponding in position to the tongue (133) of the release layer (13), and the tongue (133) extends through the notch (23).

6. The device as claimed in claim 5, wherein a bottom surface of the protective layer (14) has a low-tack adhesive layer that is located between a region of the peripheral portion (141) and the frame-shaped top surface (22) of the application apparatus (20).

7. The device as claimed in claim 1, wherein the application apparatus (50) has a sharp edge (521) downwardly from a frame-shaped top surface (52) to form a padding portion (522).

8. The device as claimed in claim 7, wherein
the application apparatus (50) further comprises at least two protrusions (523) mounted on at least one latitudinal side of the padding portion (522) of the application apparatus (50), and at least two openings (412) are provided on at least one side of a peripheral portion (411) of the protective layer (41) corresponding to the protrusions (523), wherein the openings (412) of the protective layer (41) are configured for coupling the screen protector (40) to the application apparatus (50).

9. The device as claimed in claim 1, wherein at least two protrusions (523) are spaced aligned along a side of the frame-shaped top surface (22) of the application apparatus (20), wherein the screen protector (40) further comprises at least two openings (412) corresponding to the protrusions (523), which are configured for coupling the screen protector (40) to the application apparatus (20).

10. The device as claimed in claim 8, wherein the at least two protrusions (523) are mounted respectively on each latitudinal side of the frame-shape top surface (52) of the application apparatus (50), and the positions of the protrusions (523) may be opposite to each other at the middle or corners of the frame-shaped top surface (52) of the application apparatus (50).

11. The device as claimed in claim 7, wherein the internal hollow region (51) of the application apparatus (50) has a side formed with a notch (53) corresponding in position to a tongue (431) of the release layer (43), and the tongue (431) extends through the notch (53).

12. The device as claimed in claim 7, wherein a notch (53) is formed at the corner or an edge of the application apparatus (50), and a position of a tongue (431) of the release layer (43) is corresponding to the notch (53).

13. A method for installing a screen protector (10, 40) by using a device for installing a screen protector as claimed in any of the preceding claims, comprising:
peeling off the release layer (13) of the screen protector (10, 40) under the application apparatus (20) for exposing the adhesive film layer (12);
mounting the internal hollow region (21) of the application apparatus (20) downward on a targeted electronic device (30) to make the adhesive film layer (12) fully attached to one side of the targeted electronic device (30);
moving the application apparatus (20) further downward to the side of the targeted electronic device (30) opposite to the side of the targeted electronic device (30) covered with the adhesive film layer (12) to separate the application apparatus (20) from the targeted electronic device (30); and
peeling off the protective layer (11, 41) of the screen protector (10, 40) from the adhesive film layer (12).

## Patentansprüche

1. Vorrichtung zum Anbringen eines Bildschirmschutzes, umfassend:
eine Displayschutzfolie (10), welche der Reihe nach, von oben nach unten, eine Schutzschicht (11), eine Klebefilmschicht (12) und eine Trennschicht (13) beinhaltet, die miteinander verbunden sind, wobei die Oberfläche der Schutzschicht (11) größer ist als die Klebefilmschicht (12) und die Trennschicht (13), wobei die Oberfläche der Klebefilmschicht (12) nicht größer als die Trennschicht (13) ist, sodass die Schutzschicht (11) und die Trennschicht (13) die zwei Seiten der Klebefilmschicht (12) vollständig abdecken, um die Klebefilmschicht (12) vor dem Gebrauch vor Staub oder anderen Kontaminationsquellen zu schützen, wobei die Schutzschicht (11), die Klebefilmschicht (12) und die Trennschicht (13) Öffnungen (111, 121, 131) und Rillen (112, 122, 132) haben, die jeweils mit Arbeitsöffnungen korrespondieren, welche für die funktionellen Strukturen einer elektronischen Zielvorrichtung (30), an welcher die Displayschutzfolie (10) angewendet werden soll, bestimmt sind,
eine Auftragungseinrichtung (20), welche eine rahmenartige Struktur ist, die einen innenliegenden hohlen Bereich (21), der als Durchgangsloch zur Aufnahme der Displayschutzfolie (10) ausgebildet ist, und eine rahmenförmige obere Fläche (22) umfasst und konfiguriert ist, um die Klebefilmschicht (12) der Displayschutzfolie (10) auf einer Oberfläche der elektronischen Zielvorrichtung (30) zu befestigen, und eine bestimmte Dicke hat, welche zur Anbringung der Displayschutzfolie (10) leicht von Hand gehalten werden kann,
wobei die Schutzschicht (11) einen Randabschnitt (113) umfasst, der sich nach außen über die Klebefilmschicht (12) oder die Trennschicht (13) hinaus erstreckt,
**dadurch gekennzeichnet, dass**
der Randabschnitt (113) an der rahmenförmigen oberen Fläche (22) anbringbar ist, wobei die Auftragungseinrichtung (20) eine bestimmte Dicke hat, welche kleiner als die Dicke der elektronischen Zielvorrichtung (30) ist, sodass die Auftragungseinrichtung (20) entlang einer Außenkontur der elektronischen Zielvorrichtung (30) vertikal nach unten beweglich ist, nachdem eine Trennschicht (13), die unter der Klebefilmschicht (12) angebracht ist, entfernt wurde.

2. Vorrichtung nach Anspruch 1, bei welcher die Trennschicht (13) ferner eine Zunge (133) umfasst, die an einer Längsseite der Trennschicht (13) ausgebildet ist.

3. Vorrichtung nach Anspruch 2, bei welcher die Zunge (133) einteilig mit der Trennschicht (13) ausgebildet ist.

4. Vorrichtung nach Anspruch 2, bei welcher die Zunge (133) außen an der Trennschicht (13) befestigt ist und selektiv an einem Verlängerungsabschnitt (134) der Trennschicht (13) befestigt ist.

5. Vorrichtung nach Anspruch 2, bei welcher der innenliegende hohle Bereich (21) der Auftragungseinrichtung (20) eine Seite hat, die mit einer Aussparung (23) ausgebildet ist, deren Position mit derjenigen der Zunge (133) der Trennschicht (13) korrespondiert, wobei sich die Zunge (133) durch die Aussparung (23) erstreckt.

6. Vorrichtung nach Anspruch 5, bei welcher eine untere Oberfläche der Schutzschicht (14) eine schwachklebende Haftschicht aufweist, die zwischen einem Bereich des Randabschnitts (141) und der rahmenförmigen oberen Fläche (22) der Auftragungseinrichtung (20) angeordnet ist.

7. Vorrichtung nach Anspruch 1, bei welcher die Auftragungseinrichtung (50) eine scharfen Rand (521) hat, der von einer rahmenförmigen oberen Fläche (52) nach unten geht, um einen Polsterabschnitt (522) zu bilden.

8. Vorrichtung nach Anspruch 7, bei welcher
die Auftragungseinrichtung (50) ferner wenigstens zwei Vorsprünge (523) umfasst, die an wenigstens einer Breitenseite des Polsterabschnitts (522) der Auftragungseinrichtung (50) angebracht sind, und
wenigstens zwei mit den Vorsprüngen (523) korrespondierende Öffnungen (412) an wenigstens einer Seite eines Randabschnitts (411) der Schutzschicht (41) vorgesehen sind, wobei die Öffnungen (412) der Schutzschicht (41) zur Kopplung der Displayschutzfolie (40) mit der Auftragungseinrichtung (50) konfiguriert sind.

9. Vorrichtung nach Anspruch 1, bei welcher wenigstens zwei Vorsprünge (523) voneinander beabstandet entlang einer Seite der rahmenförmigen oberen Fläche (22) der Auftragungseinrichtung (20) ausgerichtet sind, wobei die Displayschutzfolie (40) ferner wenigstens zwei mit den Vorsprüngen (523) korrespondierende Öffnungen (412) umfasst, die zur Kopplung der Displayschutzfolie (40) mit der Auftragungseinrichtung (20) konfiguriert sind.

10. Vorrichtung nach Anspruch 8, bei welcher die wenigstens zwei Vorsprünge (523) entsprechend an jeder Breitenseite der rahmenförmigen oberen Fläche (52) der Auftragungseinrichtung (50) angebracht sind, wobei die Positionen der Vorsprünge (523) einander gegenüberliegend in der Mitte oder an den Ecken der rahmenförmigen oberen Fläche (52) der Auftragungseinrichtung (50) sein können.

11. Vorrichtung nach Anspruch 7, bei welcher der innenliegende hohle Bereich (51) der Auftragungseinrichtung (50) eine Seite hat, die mit einer Aussparung (53) ausgebildet ist, deren Position mit derjenigen einer Zunge (431) der Trennschicht (43) korrespondiert, wobei sich die Zunge (431) durch die Aussparung (53) erstreckt.

12. Vorrichtung nach Anspruch 7, bei welcher eine Aussparung (53) an der Ecke oder einer Kante der Auftragungseinrichtung (50) ausgebildet ist, wobei eine Position einer Zunge (431) der Trennschicht (43) mit der Aussparung (53) korrespondiert.

13. Verfahren zum Anbringen einer Displayschutzfolie (10, 40) unter Verwendung einer Vorrichtung zum Anbringen eines Bildschirmschutzes nach einem der vorhergehenden Ansprüche, umfassend:
Abziehen der Trennschicht (13) der Displayschutzfolie (10, 40) unter der Auftragungseinrichtung (20), um die Klebefilmschicht (12) freizulegen,
Abwärts gerichtetes Anbringen des innenliegenden hohlen Bereichs (21) der Auftragungseinrichtung (20) an einer elektronischen Zielvorrichtung (30), sodass die Klebefilmschicht (12) vollständig an einer Seite der elektronischen Zielvorrichtung (30) befestigt wird,
Bewegen der Auftragungseinrichtung (20) weiter nach unten zu derjenigen Seite der elektronischen Zielvorrichtung (30), welche der mit der Klebefilmschicht (12) bedeckten Seite der elektronischen Zielvorrichtung (30) gegenüberliegt, um die Auftragungseinrichtung (20) von der elektronischen Zielvorrichtung (30) zu trennen, und
Abziehen der Schutzschicht (11, 41) der Displayschutzfolie (10, 40) von der Klebefilmschicht (12).

## Revendications

1. Dispositif pour l'installation d'un protecteur d'écran, comprenant:
un protecteur d'écran (10), comprenant successivement, de haut en bas, une couche protectrice (11), une couche de film adhésif (12) et une couche détachable (13), liées les unes aux autres, dans lequel la surface de la couche protectrice (11) est plus grande que la couche de film adhésif (12) et la couche détachable (13), et la surface de la couche de film adhésif (12) n'est pas plus grande que la couche détachable (13), de sorte que la couche protectrice (11) et la couche détachable (13) couvrent complètement les deux côtés de la couche de film adhésif (12) pour protéger la couche de film adhésif (12) des poussières ou autres sources de contamination avant utilisation, dans lequel la couche protectrice (11), la couche de film adhésif (12) et la couche détachable (13) possèdent des ouvertures (111, 121, 131) et des rainures (112, 122, 132) correspondant respectivement à des ouvertures réservées pour les structures fonctionnelles d'un dispositif électronique ciblé (30) auquel le protecteur d'écran (10) est destiné à être appliqué, un appareil d'application (20) étant une structure de type cadre comprenant une région creuse interne (21) formée en tant que trou traversant destiné à contenir le protecteur d'écran (10) et une surface supérieure en forme de cadre (22) et étant configurée pour fixer la couche de film adhésif (12) du protecteur d'écran (10) sur une surface du dispositif électronique ciblé (30), et possédant une certaine épaisseur qui peut être facilement tenue à la main pour installer le protecteur d'écran (21),
dans lequel la couche protectrice (11) comprend une partie périphérique (113) s'étendant vers l'extérieur au-delà de la couche de film adhésif (12) ou de la couche détachable (13) **caractérisé en ce que**
la partie périphérique (113) se fixe à la surface supérieure en forme de cadre (22), et
l'appareil d'application (20) possède une certaine épaisseur plus petite que l'épaisseur du dispositif électronique ciblé (30), de sorte que l'appareil d'application (20) peut être déplacé verticalement vers le bas le long d'un contour externe du dispositif électronique ciblé (30) après le retrait d'une couche détachable (13) liée sous la couche de film adhésif (12).

2. Dispositif selon la revendication 1, dans lequel la couche détachable (13) comprend en outre une languette (133) formée au niveau d'un côté longitudinal de la couche

3. Dispositif selon la revendication 2, dans lequel la languette (133) est formée en une seule pièce avec la couche détachable (13).

4. Dispositif selon la revendication 2, dans lequel la languette (133) est fixée de façon externe à la couche détachable (13) et est fixée de façon sélective à une partie d'extension (134) de la couche détachable (13).

5. Dispositif selon la revendication 2, dans lequel la région creuse interne (21) de l'appareil d'application (20) possède un côté formé avec une encoche (23) correspondant en position à la languette (133) de la couche détachable (13), et la languette (133) s'étend à travers l'encoche (23).

6. Dispositif selon la revendication 5, dans lequel une surface inférieure de la couche protectrice (14) possède une couche adhésive à faible pégosité qui se situe entre une région de la partie périphérique (141) et la surface supérieure en forme de cadre (22) de l'appareil d'application (20).

7. Dispositif selon la revendication 1, dans lequel l'appareil d'application (50) possède un bord effilé (521) vers le bas à partir d'une surface supérieure en forme de cadre (52) pour former une partie de rembourrage (522).

8. Dispositif selon la revendication 7, dans lequel l'appareil d'application (50) comprend en outre au moins deux parties saillantes (523) montées sur au moins un côté latitudinal de la partie de rembourrage (522) de l'appareil d'application (50), et au moins deux ouvertures (412) sont fournies sur au moins un côté d'une partie périphérique (411) de la couche protectrice (41) correspondant aux parties saillantes (523), dans lequel les ouvertures (412) de la couche protectrice (41) sont configurées pour coupler le protecteur d'écran (40) à l'appareil d'application (50).

9. Dispositif selon la revendication 1, dans lequel au moins deux parties saillantes (523) sont espacées en alignement le long d'un côté de la surface supérieure en forme de cadre (22) de l'appareil d'application (20), dans lequel le protecteur d'écran (40) comprend en outre au moins deux ouvertures (412) correspondant aux parties saillantes (523), lesquelles sont configurées pour coupler le protecteur d'écran (40) à l'appareil d'application (20).

10. Dispositif selon la revendication 8, dans lequel lesdites au moins deux parties saillantes (523) sont montées respectivement sur chaque côté latitudinal de la surface supérieure en forme de cadre (52) de l'appareil d'application (50), et les positions des parties saillantes (523) peuvent être opposées l'une à l'autre au milieu ou aux coins de la surface supérieure en forme de cadre (52) de l'appareil d'application (50).

11. Dispositif selon la revendication 7, dans lequel la région creuse interne (51) de l'appareil d'application (50) possède un côté formé avec une encoche (53) correspondant en position à une languette (431) de la couche détachable (43), et la languette (431) s'étend à travers l'encoche (53).

12. Dispositif selon la revendication 7, dans lequel une encoche (53) est formée au niveau du coin ou d'un bord de l'appareil d'application (50), et une position d'une languette (431) de la couche détachable (43) correspond à l'encoche (53).

13. Procédé d'installation d'un protecteur d'écran (10, 40) en utilisant un dispositif pour installer un protecteur d'écran selon l'une quelconque des revendications précédentes, comprenant:
le décollement de la couche détachable (13) du protecteur d'écran (10, 40) sous l'appareil d'application (20) afin d'exposer la couche de film adhésif (12);
le montage de la région creuse interne (21) de l'appareil d'application (20) vers le bas sur un dispositif électronique ciblé (30) pour rendre la couche de film adhésif (12) complètement fixée à un côté du dispositif électronique ciblé (30);
le déplacement de l'appareil d'application (20) davantage vers le bas vers le côté du dispositif électronique ciblé (30) opposé au côté du dispositif électronique ciblé (30) couvert avec la couche de film adhésif (12) afin de séparer l'appareil d'application (20) du dispositif électronique ciblé (30); et
le décollement de la couche protectrice (11, 41) du protecteur d'écran (10, 40) de la couche de film adhésif (12).
